# FASCICULE DE BREVET EUROPEEN

(11) **EP 4 494 224 B1**
(45) Date de publication et mention de la délivrance du brevet: **26.03.2025**
(21) Numéro de dépôt: 23700293.6
(22) Date de dépôt: 13.01.2023
(51) Int. Cl.: H01S 5/0687, H01S 5/40, H01S 5/00

(54) **SYSTÈME PHOTONIQUE COMPRENANT UNE SOURCE LASER APTE À ÉMETTRE UN RAYONNEMENT LUMINEUX MULTISPECTRAL**
PHOTONISCHES SYSTEM MIT EINER LASERQUELLE MIT DER FÄHIGKEIT, MULTISPEKTRALE LICHTSTRAHLUNG ZU EMITTIEREN
PHOTONIC SYSTEM COMPRISING A LASER SOURCE CAPABLE OF EMITTING MULTISPECTRAL LIGHT RADIATION

(30) Priorité: 15.03.2022 FR 2202254
(43) Date de publication de la demande: 22.01.2025
(73) Titulaire: Scintil Photonics, 38040 Grenoble (FR)
(72) Inventeur: MENEZO, Sylvie, 38040 Grenoble (FR); ENAULT, Florian, 22140 Bégard (FR)
(74) Mandataire: IP Trust
(86) Numéro de dépôt international: PCT/EP2023/050708
(87) Numéro de publication internationale: WO 2023/174590

(56) Documents cités:
- EP-A1- 2 573 961
- WO-A1-2013/044863
- US-A1- 2002 048 063
- US-A1- 2009 232 493
- US-B1- 6 349 103
- HATTINK MAARTEN ET AL: "Streamlined Architecture for Thermal Control and Stabilization of Cascaded DWDM Micro-Ring Filters Bus", 2022 OPTICAL FIBER COMMUNICATIONS CONFERENCE AND EXHIBITION (OFC), OSA, 6 March 2022 (2022-03-06), pages 1 - 3, XP034109709

## Description

### DOMAINE DE L'INVENTION

La présente invention concerne une source laser pour émettre un rayonnement lumineux présentant une pluralité de raies spectrales séparées d'un intervalle spectral déterminé. Une telle source trouve une application toute particulière dans le domaine des communications par multiplexage en longueur d'onde.

### ARRIERE PLAN TECHNOLOGIQUE DE L'INVENTION

Le document « WDM Source Based on High-Power, Efficient 1280-nm DFB Lasers for Terabit Interconnect Technologies », de B. Buckley, IEEE PHOTONICS TECHNOLOGY LETTERS, VOL. 30, NO. 22, NOVEMBER 15, 2018, propose une source laser formée d'une banque de lasers à rétroaction répartie. Chaque laser comprend un réseau de Bragg distribué le long de la cavité laser. Les lasers émettent des rayonnements lumineux à des longueurs d'onde étagées, typiquement écartées de 100GHz ou de 50GHz les unes des autres.

Les rayonnements lumineux émis par les lasers sont propagés aux ports d'entrée d'un mélangeur optique passif. Ce mélangeur produit, sur ses ports de sortie, une pluralité de rayonnements lumineux combinant chacun les rayonnements lumineux fournis sur ses ports d'entrée. Les rayonnements de sortie produits sur ces ports de sortie sont donc multispectraux (en peigne spectral, chaque raie du peigne correspondant au rayonnement émis par un laser de la banque).

Du fait des imprécisions et de la variabilité des procédés de fabrication des lasers, leurs longueurs d'onde d'émission sont mal maitrisées. Cela induit une variabilité de l'intervalle spectral présent entre deux raies spectrales d'un rayonnement multispectral, de l'ordre de plus ou moins 5 à 10% de l'intervalle spectral attendu, voire plus suivant l'intervalle. Les longueurs d'onde des rayonnements lumineux émis par les lasers sont également sensibles à la température d'opération, cette dernière pouvant évoluer par exemple de 0 à 80°C.

L'intervalle spectral du rayonnement lumineux fourni par une source laser multispectrale de l'état de la technique est donc mal maitrisé et susceptible de dériver au cours du fonctionnement de cette source.

Le document « Streamlined Architecture for Thermal Control and Stabilization of Cascaded DWDM Micro-Ring Filters Bus » présenté par Maarten Hattink lors de la conférence Optical Fiber Conference, tenue du 6 au 10 mars 2022, propose une solution visant à compenser cette limitation. L'approche retenue par ce document vise à verrouiller des filtres sur les fréquences d'émission de source laser multispectrale. A cet effet, les fréquences de résonance des filtres sont modulées afin de produire des signaux d'asservissement des fréquences de résonance des filtres. Cette approche nécessite toutefois une calibration du dispositif qui rend la solution particulièrement lourde à exploiter. Le choix des fréquences de modulation proposé par ce document conduit à introduire des termes d'erreur sur les signaux d'asservissement. Cette configuration présente le risque de verrouiller plusieurs modulateurs sur une unique fréquence d'émission.

Les documents WO2013044863A1, US20090232493A1 et EP2573961A1 proposent des solutions pour détecter la dérive en longueur d'onde d'une source lumineuse et la verrouiller à une longueur d'onde choisie.

### OBJET DE L'INVENTION

Un but de l'invention est de proposer une solution au moins partielle à ce problème. Plus spécifiquement, un but de l'invention est de proposer une source laser apte à fournir un rayonnement lumineux multispectral dont l'intervalle spectral est mieux maitrisé que celui présent dans les rayonnements lumineux produits par les sources laser de l'état de la technique. Un autre but de l'invention est de fournir une source laser permettant de verrouiller une fréquence de résonance accordable d'au moins un filtre d'un composant photonique.

### BREVE DESCRIPTION DE L'INVENTION

En vue de la réalisation de ce but, l'objet de l'invention propose un système photonique comprenant une source laser apte à émettre au moins un rayonnement lumineux multispectral présentant une pluralité de raies spectrales, le système photonique comprenant :
- Une banque de lasers comprenant une pluralité de lasers, une raie spectrale du rayonnement lumineux multispectral correspondant à une fréquence d'émission d'un laser de la banque ;
- un modulateur associé à la banque de lasers, le modulateur étant configuré pour générer un signal de modulation et pour moduler la fréquence d'émission d'au moins un laser de la banque ;
- un composant photonique disposé en aval de la banque de lasers et comprenant une pluralité de filtres optiques accordables présentant respectivement une pluralité de fréquences de résonance ;
- Un photodétecteur disposé en aval du composant photonique pour établir un signal représentatif d'un rayonnement multispectral produit par le composant photonique ;
- un dispositif de verrouillage configuré pour traiter le signal représentatif du rayonnement multispectral et ajuster les fréquences de résonance des filtres optiques accordables du composant photonique aux fréquences d'émission des lasers de la banque.

Selon d'autres caractéristiques avantageuses et non limitatives de l'invention, prises seules ou selon toute combinaison techniquement réalisable :
- filtres optiques accordables du composant photonique sont des micro-résonateurs en anneau ;
- les filtres optiques accordables sont respectivement munis de dispositifs d'ajustement de leur fréquence de résonance ;
- les dispositifs d'ajustement de la fréquence de résonance sont des réchauffeurs ;
- les lasers sont des lasers à rétroaction répartie ou des lasers à réflecteur de Bragg distribué ;
- le dispositif de verrouillage est configuré pour commander le modulateur et sélectionner, à l'aide d'un signal de sélection, un laser de la banque auquel est appliqué le signal de modulation ;
- le modulateur génère une pluralité de signaux de modulation distincts les uns des autres, les signaux de modulation étant appliqués aux lasers de la banque ;
- l'ajustement des fréquences de résonance des filtres optiques accordables est réalisé un filtre optique à la fois ;
- le modulateur est configuré pour produire un signal de modulation sinusoïdal présentant une fréquence de modulation ;
- le dispositif de verrouillage est configuré pour établir une mesure représentative de la puissance présente dans une deuxième harmonique de la fréquence de modulation du signal représentatif du rayonnement multispectral ;
- le dispositif de verrouillage est configuré pour établir une mesure représentative de la puissance présente dans une composante principale de la fréquence de modulation du signal représentatif du rayonnement multispectral ;
- le dispositif de verrouillage est configuré pour établir une mesure représentative de la phase de la composante principale de la fréquence de modulation du signal représentatif du rayonnement multispectral ;
- le composant photonique est un modulateur radiofréquence ;
- le composant photonique est un démodulateur radiofréquence.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1a]
[Fig. 1b]
[Fig. 1c]
[Fig. 1d]
[Fig. 1e] Les figures 1a, 1b, 1c, 1d et 1e représentent des schémas des principes sous-tendant l'invention ;
[Fig. 2a] La figure 2a représente un premier aspect de la description ;
[Fig. 2b]

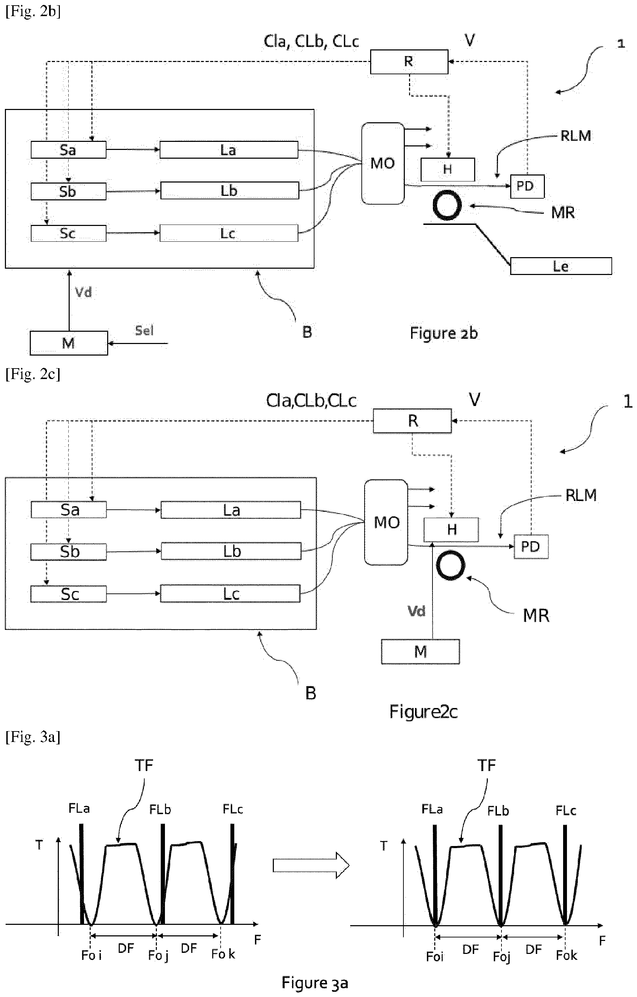

[Fig. 2c] La figure 2b et la figure 2c représentent deux variantes du premier aspect;
[Fig. 3a] La figure 3a représente le passage d'un état naturel à l'état verrouillé;

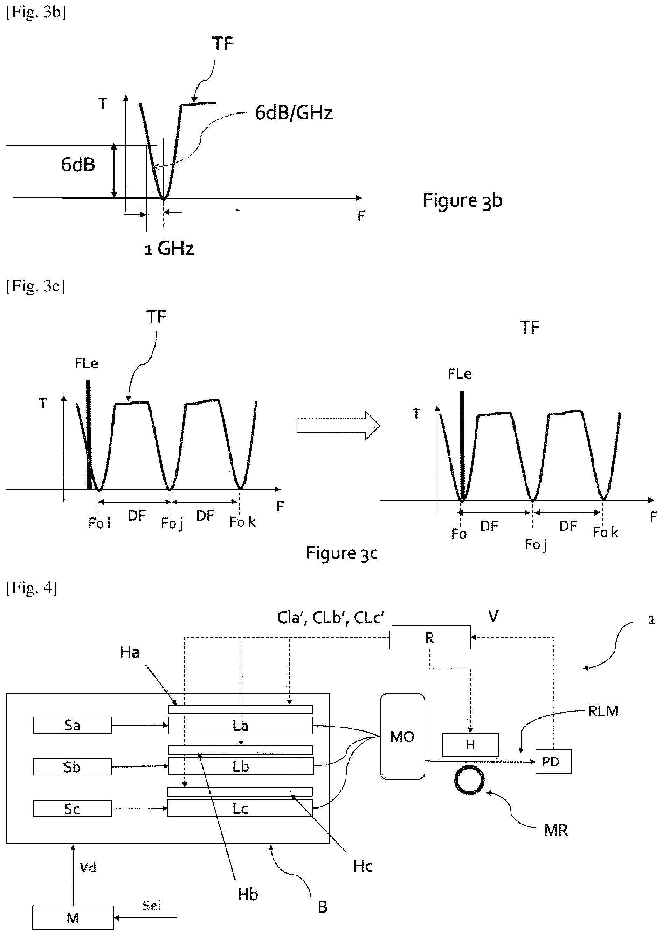

[Fig. 3b] La figure 3b représente une caractéristique avantageuse d'une fonction de transmission d'un filtre d'une source laser conforme au premier aspect;
[Fig. 3c] La figure 3c illustre un étalonnage d'un filtre d'une source laser conforme au premier aspect ;
[Fig. 4]

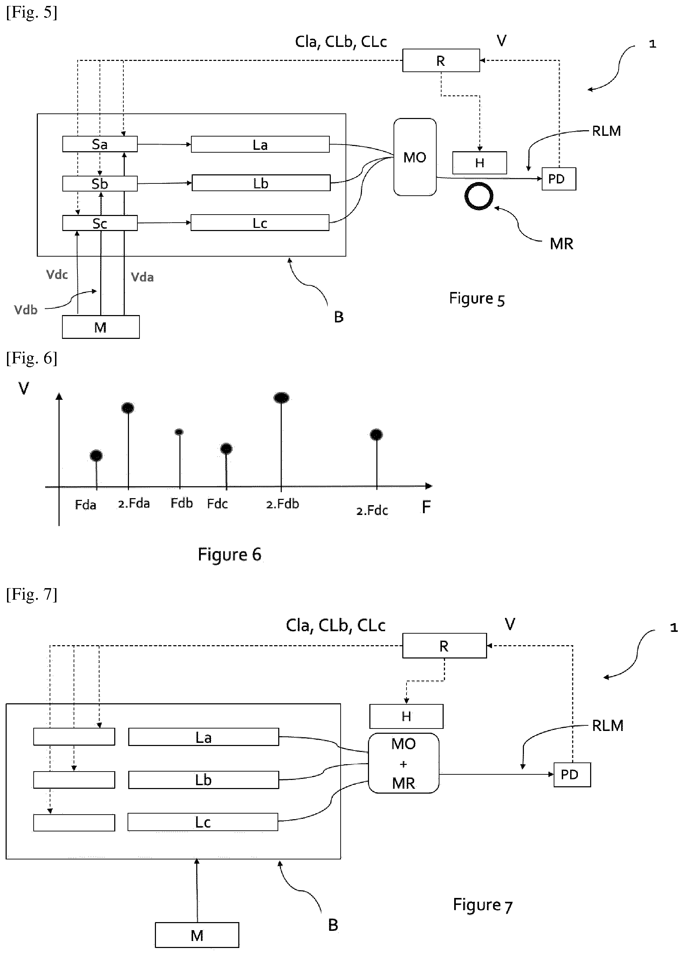

[Fig. 5] Les figures 4 et 5 représentent d'autres exemples du premier aspect;
[Fig. 6] La figure 6 représente le signal fourni par le photodétecteur dans le domaine fréquentiel, dans le cadre du mode de réalisation de la figure 5 ;
[Fig. 7] La figure 7 représente une variante applicable à tous les exemples du premier aspect ;
[Fig. 8a]
[Fig. 8b]

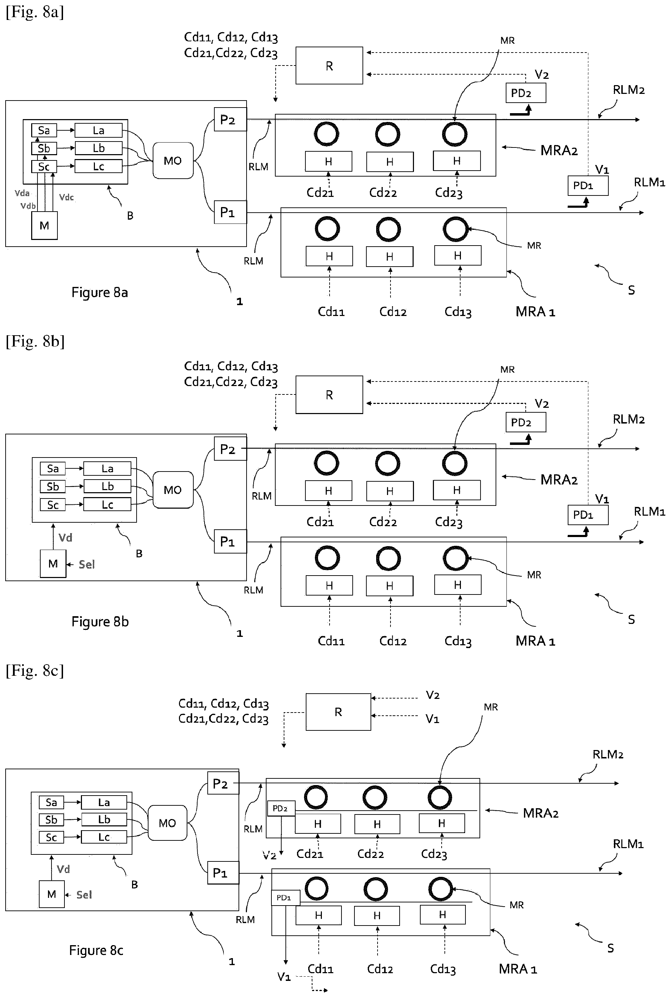

[Fig. 8c] Les figures 8a,8b,8c illustrent un deuxième aspect de la description correspondant à l'invention ;
[Fig. 9a]

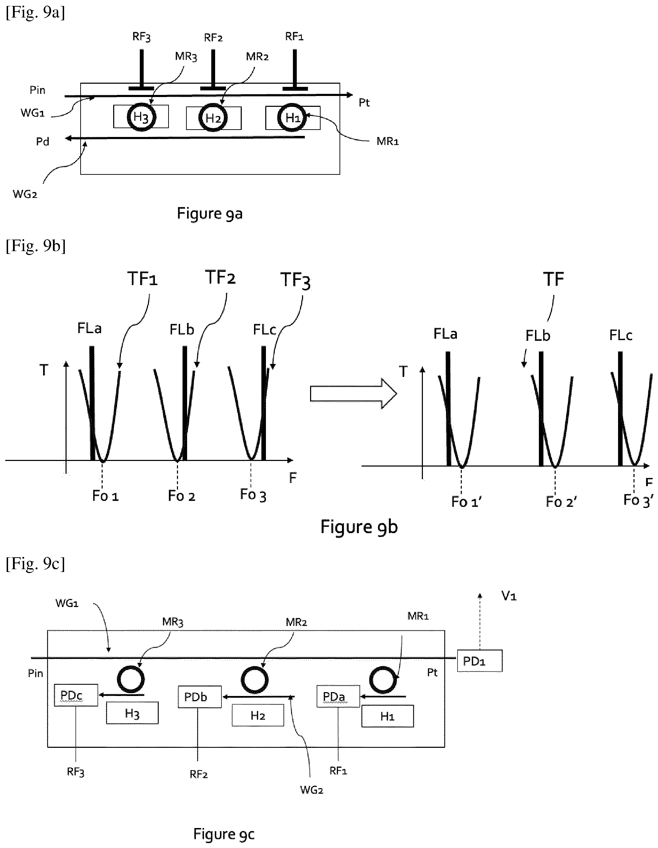

La figure 9a représente un modulateur pouvant être employé dans un système photonique conforme à l'invention ;
[Fig. 9b] La figure 9b illustre un étalonnage d'un modulateur;
[Fig. 9c]
La figure 9c représente un démodulateur pouvant être employé dans un système photonique conforme à l'invention ;

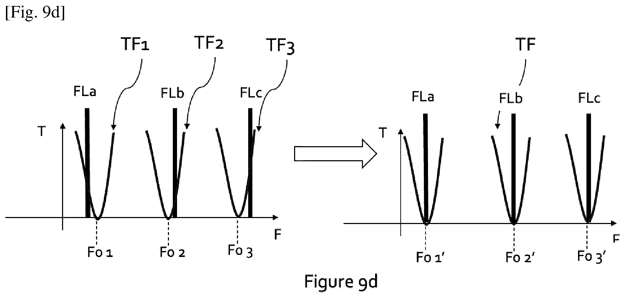

[Fig. 9d] La figure 9d illustre un étalonnage d'un démodulateur.

### DESCRIPTION DETAILLEE DE L'INVENTION

### Principes de l'invention

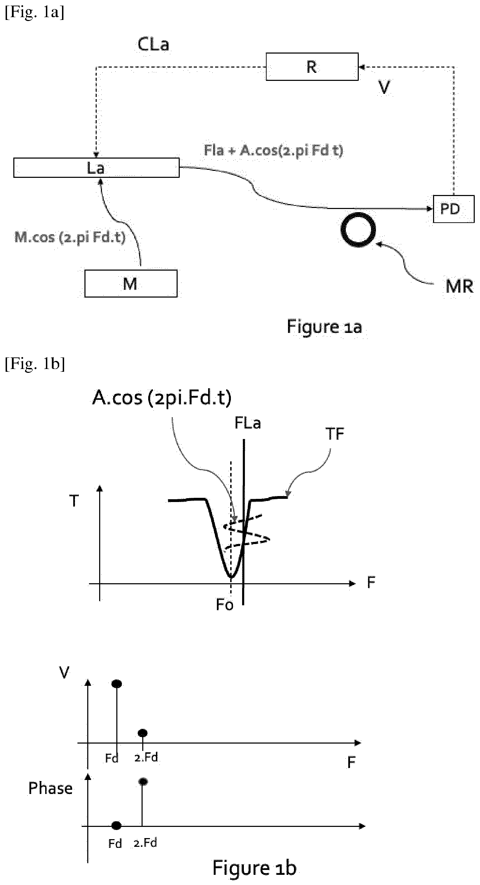

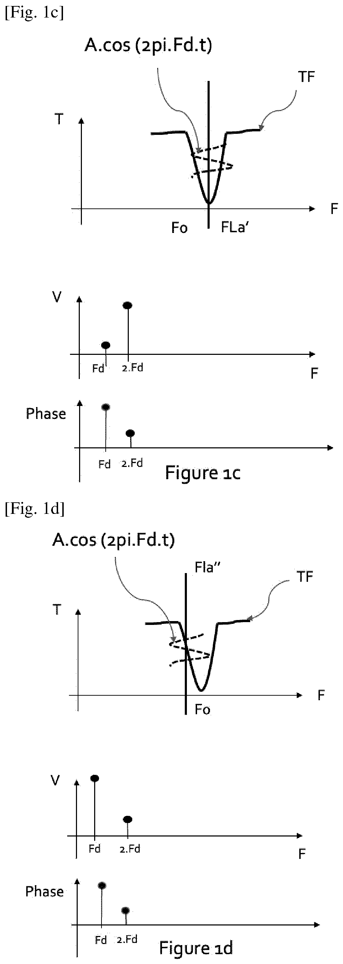

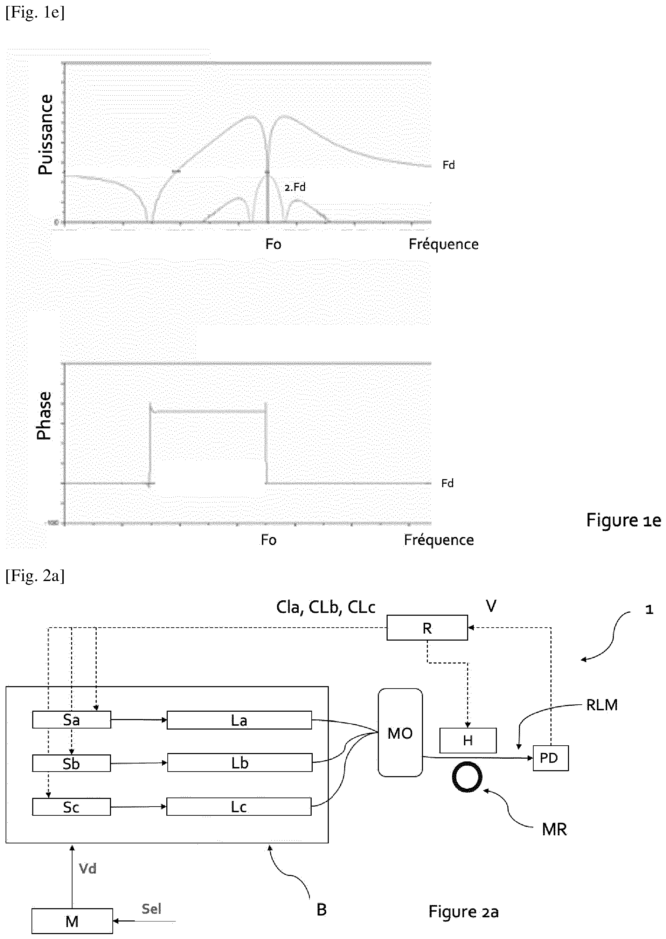

Les figures 1a, 1b, 1c, 1d et 1e sont des schémas des principes sous-tendant l'invention. Sur l'architecture de la figure 1a, un rayonnement lumineux issu d'un laser accordable La est guidé vers un résonateur en anneau MR, constituant un filtre présentant une fréquence de résonance F0, et vers un photodétecteur PD disposé en aval du résonateur MR.

Par « laser accordable », on désigne un laser produisant un rayonnement lumineux dont la fréquence (« la fréquence d'émission ») peut être ajustée. A titre d'illustration, un moyen d'ajustement de la fréquence d'émission dont le laser peut être pourvu peut comprendre un dispositif configuré pour modifier son courant d'alimentation, sa température, son indice, la concentration en porteurs libres. Un laser accordable peut être muni d'une pluralité de moyens d'ajustement de sa fréquence d'émission, par exemple une source de courant ajustable et un réchauffeur permettant de modifier la température de fonctionnement du laser.

Un modulateur M, relié à un moyen d'ajustement de la fréquence d'émission du laser, est configuré pour moduler la fréquence d'émission Fla du rayonnement lumineux émis par le laser accordable La, d'une fréquence de modulation Fd. Cette fréquence de modulation Fd, par exemple de 5 kHz, est relativement faible comparée à la fréquence d'émission du laser, par exemple de 200 térahertz. L'amplitude de cette modulation est également faible. A titre d'exemple, 1 mA d'amplitude de modulation du courant d'alimentation peut conduire à une variation de la fréquence d'émission FLa du laser accordable La de l'ordre de plus ou moins 1 GHz. Le rayonnement lumineux émis par le laser accordable La varie donc à très faible fréquence Fd et avec une faible amplitude A (1GHz) autour de sa fréquence fondamentale FLa. La fréquence laser varie donc comme Fla + A.cos (2pi.Fd.t).

Sur la figure 1b, on a représenté dans le domaine fréquentiel la fonction de transmission T du filtre MR dont le spectre TF présente une fréquence de résonance F0, et le signal V fourni par ce photodétecteur PD dans le cas où la fréquence d'émission FLa du laser accordable La n'est pas verrouillée sur une fréquence de résonance F0 du résonateur MR, mais présente une fréquence d'émission Fla supérieure à la cette fréquence de résonance F0. La fréquence d'émission du laser accordable La étant disposée dans une section relativement linéaire de la fonction de transmission du résonateur MR, le signal V fourni par le photodétecteur PD présente, dans le domaine fréquentiel, une composante principale Fd (correspondant à la fréquence de modulation) relativement importante vis-à-vis de ses harmoniques et notamment vis-à-vis de sa deuxième harmonique 2*Fd. Par ailleurs, la phase de la composante principale Fd du signal V est réduite, c'est-à-dire que cette composante principale est en phase avec le signal V fourni par le photodétecteur PD.

Sur la figure 1c, on a représenté, similairement à la figure 1b, la fonction de transmission T du filtre MR dont le spectre TF présente une fréquence de résonance F0 et le signal V fourni par ce photodétecteur PD dans le cas où la fréquence d'émission FLa' du laser accordable La est alignée sur la fréquence de résonance F0 du résonateur MR. Dans ce cas, la fréquence d'émission FLa' du laser accordable La est disposé dans une section relativement non linéaire de la fonction de transmission du résonateur MR. En conséquence le signal V fourni par le photodétecteur PD présente, dans le domaine fréquentiel, des composantes harmoniques 2*Fd relativement importantes vis-à-vis de de la fréquence de modulation Fd.

Enfin, sur la figure 1d, on a représenté dans le domaine fréquentiel la fonction de transmission T du filtre MR dont le spectre TF présente une fréquence de résonance F0, et le signal V fourni par ce photodétecteur PD dans le cas où la fréquence d'émission FLa du laser accordable La n'est pas alignée sur une fréquence de résonance F0 du résonateur MR, mais présente une fréquence d'émission Fla'' inférieure à la cette fréquence de résonance F0. La fréquence d'émission du laser accordable La étant disposée dans une section relativement linéaire de la fonction de transmission du résonateur MR, le signal V fourni par le photodétecteur PD présente, dans le domaine fréquentiel, une composante principale Fd relativement importante vis-à-vis de ses harmoniques, et notamment vis-à-vis de sa deuxième harmonique 2*Fd. Par ailleurs, la phase de la composante principale Fd du signal V est importante, c'est-à-dire que cette composante principale est en opposition de phase avec le signal V fourni par le photodétecteur.

La figure 1e synthétise les résultats des figures 1b, 1c et 1d et représente, dans le graphe du haut, l'évolution de la puissance présente dans la composante principale Fd et dans la deuxième harmonique 2*Fd du signal V fourni par le photodétecteur quand la fréquence d'émission FLa du laser accordable La est modifiée et que la fréquence de résonance du filtre reste fixe (ou vice versa). La figure 1e représente également, dans le graphe du bas, l'évolution de la phase de la composante principale Fd du signal V fourni par le photodétecteur.

Revenant à la description du schéma de principe de la figure 1a, un dispositif de verrouillage R reçoit le signal V établi par le photodétecteur et le traite pour élaborer une commande CLa du laser accordable La visant à accorder sa fréquence d'émission à la fréquence de résonance F0 du résonateur MR. Le traitement mis en œuvre par le dispositif de verrouillage R exploite les résultats présentés dans les figures 1b,1c,1d,1e et détermine la commande à appliquer au moyen d'ajustement de la fréquence d'émission du laser qui optimise la part du signal présent dans la composante principale ou dans la seconde harmonique 2*Fd du signal fourni par le photodétecteur PD. On note que la part du signal présent dans la composante principale et la part du signal présent dans la seconde harmonique 2*Fd sont liées l'une à l'autre, comme cela est bien visible sur la figure 1e, si bien que l'on pourra choisir d'exploiter l'une et/ou l'autre selon le besoin. On pourra également exploiter la phase, comme cela a été illustré précédemment.

A titre d'illustration, le dispositif de verrouillage R peut appliquer au dispositif d'ajustement une succession de commande CLa s'incrémentant d'une valeur minimale à une valeur maximale afin que la fréquence d'émission du laser La s'ajuste, au cours d'une succession d'étapes, d'une fréquence minimale d'émission à une fréquence maximale d'émission. A chaque étape, le dispositif de verrouillage R applique une transformation en fréquence au signal fourni par le photodétecteur (par exemple une transformée de Fourrier) afin de relever la part de signal présent dans la seconde harmonique et/ou dans la composante principale. A l'issue de ces étapes, on identifie l'étape et la commande CLa associée, qui a conduit à un maximum de signal dans la seconde harmonique (ou un minimum de signal dans la composante principale), cette commande CLa associée étant celle qui fait concorder au mieux la fréquence d'émission du laser La et la fréquence de résonance du filtre MR. On applique alors cette commande au dispositif d'ajustement de la fréquence d'émission du laser La afin de provoquer le verrouillage du système. D'autres approches sont également possibles, par exemple en exploitant, dans une boucle de régulation conduisant à incrémenter ou décrémenter d'un pas prédéterminé la commande Cla fournie au dispositif d'ajustement de la fréquence, l'information de phase de la fréquence principale Fd du signal fourni par le photodétecteur PD. Comme on l'a déjà noté, cette information indique si la fréquence d'émission du laser est inférieure à la fréquence de résonance du laser (phase importante), ou supérieure à cette fréquence (phase nulle ou faible).

On peut rechercher à faire concorder la fréquence d'émission du laser La avec la fréquence de résonance du filtre MR, comme cela vient d'être présenté à titre d'exemple. Alternativement, on peut rechercher à les positionner l'une par rapport à l'autre d'un écart déterminé. D'une manière générale, la détermination de la commande CLa est réalisée par optimisation d'une fonction prenant en argument la part du signal présente dans la composante principale et/ou dans la seconde harmonique 2*Fd du signal de contrôle V. Le critère d'optimisation peut correspondre à ce que la fonction atteigne une valeur cible, soit inférieure à une valeur plafond prédéterminée ou soit supérieure à une valeur seuil prédéterminée. On peut également prévoir d'exploiter la phase de la composante principale et/ou de la seconde harmonique 2*Fd du signal de contrôle V.

A titre d'exemple, on peut ainsi chercher à fixer le rapport entre la part de signal présent dans la seconde harmonique et la part du signal présent dans la composante principale pour qu'il soit égal à une valeur cible ou pour le maximiser.

Par souci de précision, on dira que le système est « verrouillé » lorsque le critère d'optimisation choisi est satisfait. Cela peut correspondre à la situation dans laquelle la fréquence d'émission Fla et la fréquence de résonance F0 se correspondent ou lorsque ces fréquences sont décalées l'une de l'autre d'un écart déterminé.

On note qu'en appliquant un signal de modulation sinusoïdal, on limite l'apparition d'harmoniques dans le signal fourni par le photodétecteur PD (par comparaison avec une modulation en créneau par exemple), les harmoniques détectées par le dispositif de verrouillage R étant alors bien représentatives de la qualité du verrouillage entre la fréquence d'émission et la fréquence de résonance.

On note également que les mêmes principes de verrouillage sont applicables à une configuration dans laquelle le dispositif d'ajustement est associé au filtre de manière à ajuster sa fréquence de résonance.

### Premier aspect de la présente description

Selon un premier aspect de la présente description qui ne fait pas l'objet de l'invention, on exploite les principes qui viennent d'être présentés pour proposer une source laser d'un rayonnement lumineux multispectral, présentant donc une pluralité de raies spectrales, ces raies spectrales étant séparées d'un intervalle spectral maitrisé. A titre d'exemple, pour des applications dans le domaine de la transmission par multiplexage par répartition en longueur d'onde, on cherche à fournir une source laser d'un rayonnement lumineux multispectral dont les raies spectrales sont précisément séparées (à 5% près) d'un intervalle de 100GHz ou de 50 GHz par exemple.

En référence à la figure 2a , qui présente un premier exemple, une telle source 1 comprend une banque B de lasers accordables La, Lb, Lc. A titre d'exemple, les lasers accordables de la banque B peuvent être des lasers à rétroaction répartie. Comme cela est bien connu en soi, chaque laser comprend un réseau de Bragg distribué le long d'une cavité laser. Chaque laser La,Lb,Lc de la banque B est associé à une source de courant Sa, Sb, Sc, permettant son alimentation et la génération d'un rayonnement lumineux. Comme on l'a déjà noté, la fréquence d'émission d'un laser à rétroaction réparti est dépendant de son courant d'alimentation. En ajustant ce courant, on peut ajuster cette fréquence d'émission ce qui rend ces lasers « accordables » au sens de la présente description. La banque B peut contenir un nombre quelconque de lasers accordables, typiquement entre 4 et 100 lasers. Bien entendu l'invention n'est nullement limitée à une banque de lasers à rétroaction répartie et s'applique à tout laser accordable. Il peut dans un exemple complémentaire s'agir d'un laser du type DBR (pour « Distributed Bragg reflector laser » ou laser à réflecteur de Bragg distribué).

Les lasers de la banque B sont conçus pour émettre des rayonnements lumineux présentant des fréquences d'émission étagées, typiquement écartées d'un intervalle spectral de 100GHz pour les applications WDM, comme cela a été exposé précédemment. Toutefois, et comme cela est rendu apparent sur la partie gauche de la figure 3a (où sont représentées les fréquences Fla,Flb,Flc et la fonction de transfert du filtre FT), la variabilité du procédé de fabrication de la banque B ne permet pas de maitriser parfaitement l'intervalle spectral séparant les fréquences d'émission FLa,FLb,FLC des lasers de la banque B. L'intervalle spectral séparant deux lasers successifs (en les ordonnant par fréquence d'émission) est donc variable, et cette variation en l'absence de tout mécanisme de verrouillage peut être de l'ordre ou supérieure à +/-20%. On note également que la température de fonctionnement de la banque B peut affecter et faire dériver les fréquences d'émission des lasers.

Revenant à la description de l'exemple de la figure 2a, les lasers accordables La,Lb,Lc de la banque sont couplés à un mélangeur optique MO par l'intermédiaire de guides d'onde. Ce mélangeur MO produit au moins un rayonnement lumineux multispectral RLM, une raie spectrale de ce rayonnement correspondant à une fréquence d'émission du rayonnement lumineux émis par un laser accordable de la banque B. Le mélangeur MO peut fournir une pluralité de rayonnements lumineux mutlispectraux, identiques entre eux.

Le rayonnement lumineux multispectral RLM (ou une pluralité de tels rayonnements) forme le rayonnement dit « utile » de la source 1, c'est-à-dire le rayonnement qui peut être exploité par d'autres éléments, modulateurs optiques, routeurs optiques... lorsque par exemple la source 1 forme un composant d'un système de communication. Selon un aspect de l'invention, une partie au moins d'un rayonnement multispectral « utile » est prélevé pour permettre l'alignement des fréquences d'émission des lasers accordables de la banque B sur un peigne de fréquences présentant un intervalle spectral déterminé.

Cette partie prélevée du rayonnement lumineux multispectral est guidée vers un filtre optique MR présentant une fonction de transfert TF définissant un gabarit du peigne de fréquences présentant l'intervalle spectral DF déterminé, comme cela est rendu visible sur la figure 3a. Dit autrement, deux fréquences de résonance F0i,F0j,F0k successives du filtre MR sont séparées par un intervalle spectral déterminé DF. A titre d'exemple, le filtre optique MR peut être un résonateur, par exemple un micro résonateur en anneau ou de type Fabry Perrot, qui permet de maitriser avec précision, par exemple à 5% près, l'intervalle spectral DF présent entre deux fréquences de résonance F0i,F0j,F0k. Quelle que soit sa nature, le filtre optique MR est disposé en aval de la banque B de lasers accordables, et plus précisément en aval du mélangeur optique MO, pour ainsi recevoir le rayonnement lumineux multispectral RLM. Afin de pouvoir discriminer avec suffisamment de sensibilité un écart en fréquence imparti par la modulation, la fonction de transfert du filtre MR doit être particulièrement étroite, présentant préférentiellement une pente supérieure 6dB/GhZ, lorsque l'on s'écarte d'un gigahertz ou plus d'une de ses fréquences de résonance. Une telle caractéristique est représentée sur la figure 3b.

Le filtre optique MR peut comprendre un dispositif d'ajustement de la pluralité de ses fréquences de résonance F0i,F0j,F0k. Ainsi, lorsque le filtre MR est mis en œuvre par un résonateur en anneau, ce dispositif peut être un réchauffeur H permettant de décaler en fréquence le peigne de fréquences propres, comme cela sera exposé en détail dans une section ultérieure de la présente description.

La source 1 représentée sur la figure 2a comprend également un photodétecteur PD disposé en aval du filtre optique MR pour établir un signal V représentatif du rayonnement lumineux multispectral MLR.

Elle comprend également un modulateur M associé à la banque de lasers accordables B, le modulateur M étant commandable par l'intermédiaire d'un signal de sélection Sel. Le modulateur M a pour fonction de fournir un signal Vd modulant la fréquence d'émission du rayonnement lumineux émis par un laser accordable avec un signal de modulation de fréquence Fd. Le signal de modulation Vd, dont la forme générale est du type cos(2.Pi*Fd*t), présente un fréquence de modulation Fd relativement faible, de l'ordre de quelques kHz à quelques MHz, typiquement de l'ordre de 5kHz, de quelques 10kHz, voire 1MHz ou plus. L'amplitude du signal de modulation Vd est choisie de sorte que l'excursion en fréquence de la fréquence d'émission du rayonnement lumineux émis par un laser accordable soit de l'ordre de 1GHz ou plus. Le signal de sélection Sel de ce mode de réalisation permet de choisir le laser accordable de la banque B sur lequel sera appliquée la fréquence de modulation Fd.

Pratiquement, cette modulation de la fréquence peut être appliquée en modulant avec le signal de modulation Vd, le courant produit par la source de courant Sa,Sb,Sc associée au laser accordable La,Lb,Lc sélectionné. D'autres moyens de modulation de la fréquence d'émission du laser peuvent être exploités. Il peut ainsi s'agir d'appliquer le signal de modulation Vd sur un réchauffeur associé au laser, ou sur un dispositif injection/déplétion de porteurs libres dans le laser. D'une manière générale donc, le modulateur M est électriquement relié à la banque de laser, de manière à appliquer le signal de modulation à un moyen d'ajustement de la fréquence d'émission dont est muni le laser accordable sélectionné.

Enfin, la source laser 1 représentée sur la figure 2a comprend un dispositif de verrouillage R d'un laser accordable de la banque B. Ce dispositif de verrouillage R est relié à la banque de laser B par l'intermédiaire de commandes CLa,CLb,CLc respectivement reliées aux sources de courant Sa,Sb,Sc. Il est également relié au photodétecteur PD pour recevoir le signal V établi par cet élément et, s'il est présent, au réchauffeur H du filtre MR pour le commander. Le dispositif de verrouillage R est configuré pour commander le modulateur M et sélectionner, à l'aide du signal de sélection Sel, le laser accordable auquel est appliqué le signal de modulation Vd. Le dispositif de verrouillage R est également configuré, dans cet aspect de l'invention, pour mettre en œuvre une boucle de régulation visant à accorder la fréquence d'émission du laser accordable sélectionné Fla,Flb,Flc et la verrouiller sur une fréquence de résonance du filtre Foi,Foj,Fok. Cette boucle de régulation met en œuvre les principes exposés en relation avec la description des figures 1a à 1c. Elle peut notamment effectuer une transformée de Fourrier (ou toute autre transformation dans le domaine fréquentiel) du signal V produit par le photodétecteur PD et déterminer la part de puissance présente dans la fréquence de modulation Fd et dans ses harmoniques, notamment dans la deuxième harmonique. Le dispositif de verrouillage R peut, sur cette base, élaborer la commande associée au laser accordable sélectionné permettant d'ajuster sa fréquence d'émission pour la verrouiller sur une fréquence de résonance du filtre MR.

Dans le mode de réalisation représenté sur la figure 2a, les sources de courant Sa,Sb,Sc sont réglables, et l'ajustement de la fréquence d'émission d'un laser est réalisé en contrôlant en rétroaction son courant moyen d'alimentation fourni par la source de courant réglable associée. Comme on l'a déjà énoncé, ce courant moyen, c'est-à-dire la partie continue du courant d'alimentation du laser, affecte la fréquence d'émission de ce laser.

La source laser 1 de l'exemple représenté sur la figure 2a est mise en œuvre en sélectionnant successivement un laser accordable à verrouiller parmi les lasers accordables de la banque B. Ainsi, le dispositif de verrouillage R peut comprendre une machine d'état émettant un signal de sélection Sel sélectionnant circulairement un des lasers accordables de la banque B, par exemple au cours de périodes de verrouillage successives dont la durée peut être typiquement comprise entre quelques microsecondes à quelques millisecondes. Au cours de chaque période de verrouillage, le dispositif de verrouillage R met en œuvre les traitements conduisant à verrouiller la fréquence d'émission du laser accordable sélectionné sur la fréquence propre F0 la plus proche du filtre optique MR. A l'issue d'un cycle complet, chaque laser accordable est bien verrouillé sur une fréquence propre du filtre optique. Dans cet état verrouillé de la banque B, représenté sur la partie droite de la figure 3a, le rayonnement lumineux multispectral RLM se conforme bien au gabarit spectral imposé par le filtre optique MR : il présente une pluralité de raies spectrales FLa, FLb, FLc séparées entre elles d'un intervalle spectral déterminé DF par le filtre optique. L'intervalle spectral DF séparant deux fréquences propres F0 adjacentes du filtre étant maitrisé, typiquement à 5% près ou mieux, cette propriété peut être conférée aux fréquences d'émissions des lasers accordables de la banque B.

En répétant les cycles de régulation les uns à la suite des autres, en multiplexage temporel, on peut maintenir dans le temps l'état verrouillé de la banque de lasers accordables sur le filtre, et compenser des éventuelles dérives, notamment celles liées aux variations de température des lasers.

Optionnellement, le dispositif de verrouillage R peut mettre en œuvre une autre boucle de régulation pour étalonner le peigne de fréquences de résonance du filtre optique MR et l'aligner sur des fréquences de résonance cibles, en valeur absolue. A cet effet, et comme cela est représenté sur la figure 2b, on fournit un rayonnement lumineux issu d'un laser étalon Le sur un port complémentaire du filtre MR. Ce laser étalon Le présente une fréquence d'émission modulée, tout comme les autres lasers accordables La,Lb,Lc de la banque B. Toutefois, le laser accordable étalon Le n'est pas relié au dispositif de verrouillage R et sa fréquence d'émission, naturellement stable n'est pas ajustée par ce dispositif.

Le dispositif de verrouillage R peut extraire de la transformée de Fourrier du signal V produit par le photodétecteur PD, les composantes fréquentielles correspondant à la fréquence de modulation du laser accordable étalon et le dispositif de verrouillage R peut commander le réchauffeur H, ou tout autre dispositif d'ajustement de la pluralité des fréquences de résonance F0i,F0j,F0k du filtre, afin de décaler en fréquence ce peigne de fréquences propres et le recaler sur la fréquence cible fournie par le laser étalon. Ce fonctionnement est illustré sur la figure 3c. Cette boucle de régulation d'étalonnage du filtre MR et la boucle de régulation de verrouillage des lasers accordables ne sont pas forcément distinctes l'une de l'autre, et selon une approche possible, le dispositif de verrouillage R met en œuvre une unique boucle de régulation ou des traitements visant à simultanément optimiser la source laser 1 et le filtre MR afin de produire un rayonnement lumineux multispectral RLM présentant une pluralité de raies spectrales déterminées, c'est-à-dire dont chaque raie est précisément positionnée dans le domaine fréquentiel.

La figure 2c présente une autre variante de ce premier aspectde la description. Dans cette variante, le filtre optique MR comprend un dispositif d'ajustement H de la pluralité de ses fréquences de résonance F0i,F0j,F0k, par exemple un réchauffeur. Le signal Vd fourni par le modulateur M est, dans cette variante, appliqué au dispositif d'ajustement H du filtre optique MR. L'application de ce signal conduit donc à moduler simultanément, à la fréquence de modulation Fd, la pluralité des fréquences de résonance F0i,F0j,F0k du filtre optique MR. Cette variante présente l'avantage d'une plus grande simplicité de mise en œuvre. La source laser 1 de la figure 2c est mise en œuvre en sélectionnant successivement un laser accordable à verrouiller parmi les lasers accordables de la banque B, similairement aux explications données précédemment.

La figure 4 représente un autre exemple réalisation de la source laser 1. Dans cet exemple, chaque laser accordable La,Lb,Lc de la banque B est muni d'un réchauffeur Ha,Hb,Hc. Comme cela est bien connu en soi, le réchauffeur associé à un laser permet de maitriser finement la fréquence d'émission du laser en faisant varier sa température. Dans cette configuration de la source laser 1, les commandes CLa',CLb',CLc' élaborées par le dispositif de verrouillage R sont respectivement reliées aux réchauffeurs Ha,Hb,Hc en vue de les commanderL'ajustement de la fréquence d'émission des lasers accordables de la banque B est réalisé par l'intermédiaire des réchauffeurs Ha,Hb,Hc, en contrôlant la température du laser accordable sélectionné, et non par contrôle de son courant moyen d'alimentation comme cela était le cas dans le premier mode de mise en œuvre. Tous les autres éléments de la source laser 1 du deuxième exemple sont identiques à ceux du premier exemple et, par souci de concision, leur description ne sera pas répétée. On peut bien entendu envisager de combiner ces deux exemples, et de réaliser l'ajustement de la fréquence d'émission des lasers accordables de la banque B, en contrôlant à la fois le courant moyen d'alimentation de la source de courant associé à un laser accordable sélectionné et, simultanément, en contrôlant la température de ce laser à l'aide d'un réchauffeur associé.

Dans une autre variante de la source laser 1 représentée sur les figures 2a et 4, chaque laser La,Lb,Lc de la banque B comprend cette fois un dispositif d'injection/déplétion de porteurs, par exemple un guide d'onde disposé sous le laser La,Lb,Lc. On peut de la même manière maitriser finement la fréquence d'émission du laser en faisant varier la concentration en porteurs libres dans le dispositif disposé sous le laser. Dans la configuration de la source laser 1 de ce mode de réalisation, les commandes CLa',CLb',CLc' élaborées par le dispositif de verrouillage R sont respectivement reliées aux dispositifs d'injection/déplétion de porteurs.

Comme on l'a déjà énoncé, chaque laser accordable de la banque B de lasers peut être muni d'une pluralité de moyens d'ajustement de sa fréquence d'émission. Dans ce cas, il n'est pas nécessaire que le même moyen soit exploité pour moduler la fréquence d'émission de ce laser et pour l'ajuster à une fréquence de résonance du filtre MR. Un premier moyen peut ainsi être exploité pour moduler cette fréquence d'émission (par exemple en appliquant le signal de modulation Vd sur la source de courant d'alimentation du laser sélectionné et ainsi moduler ce courant d'alimentation) et un second moyen, différent du premier, peut être exploité pour ajuster la fréquence d'émission de ce laser à une fréquence de résonance du filtre (par exemple en maitrisant la température produite par un réchauffeur associé au laser). Dans l'exemple de la figure 5, en multiplexage fréquentiel, le modulateur M génère une pluralité de signaux de modulation Vda,Vdb,Vdc, chaque signal de modulation étant associé à un laser accordable La,Lb,Lc de la banque B. Chaque signal de modulation présente une fréquence de modulation Fda,Fdb,Fdc distincte des fréquences des autres signaux de modulation. Ces signaux sont appliqués simultanément, et avantageusement de manière permanente, sur les lasers auxquels ils sont respectivement associés, ici sur les sources de courant de ces lasers. Le modulateur M permet ainsi de moduler les fréquences d'émission des lasers accordables par l'intermédiaire d'une fréquence de modulation propre à chaque laser accordable. A titre d'exemple, les fréquences de modulation peuvent être comprises dans la gamme 1kHz à 30 kHz. Dans le cas de ce mode de réalisation, il n'est donc pas nécessaire que le modulateur M soit commandable par l'intermédiaire d'un signal de sélection. Le reste de la source laser 1 de cet exemple est identique à l'exemple de la figure 2a, et sa description sera donc omis ici par souci de concision. On peut notamment prévoir, comme dans le premier exemple, d'injecter un rayonnement fourni par un laser étalon dans un port complémentaire du filtre MR, et exploiter un réchauffeur H associé à ce filtre MR, pour précisément positionner dans le domaine fréquentiel chaque raie du rayonnement lumineux multispectral RLM.

Les traitements mis à en œuvre par le dispositif de verrouillage R sont naturellement adaptés à cet exemple, mais reposent sur les mêmes principes exposés dans les figures 1a à 1e. En particulier, l'analyse dans le domaine fréquentiel du signal V fourni par le photodétecteur fait apparaître, comme cela est visible sur la figure 6, chacune des fréquences de modulation et leurs harmoniques. Ces fréquences de modulation étant connues, le dispositif de verrouillage peut être configuré pour les identifier et mettre en œuvre les traitements visant à ajuster la fréquence d'émission du laser accordable associé.

Sur la représentation de la figure 5, les signaux de commande CLa,CLb,CLc préparés par le dispositif de verrouillage R sont respectivement reliés aux sources de courant Sa,Sb,Sc de la banque de lasers accordables. Toutefois, tout comme dans l'exemple de la figure 4, il est envisageable dans le cadre de l'exemple de la figure 5, de contrôler la fréquence d'émission des lasers accordables à l'aide de réchauffeurs respectivement associés à ces lasers accordables ou à tout autre moyen d'ajustement de la fréquence d'émission de ces lasers.

La figure 7 représente une variante applicable aux deux exemples qui viennent d'être présentés. Dans cette variante, un unique élément optique (désigné MO+MR sur la figure) met en œuvre les fonctions du mélangeur MO et du filtre MR. Il peut s'agir par exemple d'un multiplexeur mis en œuvre par un réseau de guides d'onde (« Arrayed waveguide grating » selon la terminologie anglo-saxonne) ou mis en œuvre par un réseau en échelle. Cet élément présente une fonction de transfert identique à celle présentée sur la figure 3a.

Quel que soit l'exemple choisi, une source laser 1 conforme à l'invention peut être mise en œuvre par des technologies photoniques à base de silicium. Selon ces technologies, les guides d'onde et autres composants passifs sont réalisés sur un substrat de silicium (et avantageusement sur un substrat de silicium sur isolant) et les autres éléments (sources laser, photodétecteurs, mélangeur optique, réchauffeurs) peuvent être formés, par dépôt ou par report, sur ce substrat. Cette puce photonique peut être associée à une puce électronique comprenant certains des autres composants électroniques de la source laser 1, tel que les sources de courant voire même le dispositif de verrouillage. Dans certains cas, une unique puce peut comprendre les éléments photoniques et électroniques de la source 1. Le dispositif de verrouillage, s'il n'est pas intégré dans une des puces, peut être mis en œuvre par un dispositif de calcul (un microcontrôleur, un calculateur de traitement de signal DSP ou un ASIC) disposé sur un support et auquel sont électriquement reliées la ou les puces.

On note qu'une source laser 1 conforme à ce premier aspect de la description est particulièrement intéressante, car il est possible d'accorder la fréquence d'émission des lasers accordables de la banque B à l'aide d'un circuit particulièrement simple. C'est notamment le cas de la partie photonique de la source, augmentée d'un unique photodétecteur PD et d'un unique filtre MR, par exemple un micro résonateur en anneau. On limite de la sorte le nombre de plots additionnel d'interconnexion dont la puce photonique doit être munie pour permettre la fonctionnalité de verrouillage des lasers accordables.

### Deuxième aspect et objet l'invention

Le rayonnement lumineux multispectral modulé par le signal de modulation Vd, qui forme le rayonnement « utile » fourni par la source, peut également être exploité pour la calibration et/ou le verrouillage des composants photoniques (routeurs, modulateurs, démodulateurs...) disposés en aval de la source laser 1, lorsque cette source 1 est exploitée dans un système photonique S plus complexe. Selon l'invention, on peut exploiter une source laser fournissant un rayonnement lumineux multispectral dont l'intervalle spectral est mal maitrisé.

Un exemple d'une telle utilisation d'une source laser conforme à cet aspect de l'invention est représenté sur la figure 8a (en multiplexage fréquentiel) et sur la figure 8b (en multiplexage temporel). Sur ces figures, une source laser 1 présente au moins un port de sortie (deux ports P1, P2 sur les figures 8a,8b) produisant chacun un rayonnement lumineux multispectral RLM. Ce rayonnement est donc composé spectralement d'une pluralité de raies séparées d'un intervalle spectral. Une au moins de ces raies est modulée en fréquence, comme cela a été exposé en détail en relation avec l'exposé de chacun des modes de réalisation de la source 1 (en multiplexage temporel ou fréquentiel).

On retrouve bien dans une source 1 conforme à l'invention, une banque B de lasers La,Lb,Lc. Chaque laser de la banque B est associé à une source de courant Sa, Sb, Sc, formant des moyens d'ajustement de sa fréquence d'émission, reliée au modulateur M. On peut ainsi, tout comme dans le premier aspect de la description, moduler au moins une fréquence d'émission du rayonnement multispectral RLM émis par la source 1. Les lasers accordables La,Lb,Lc de la banque B sont couplés à un mélangeur optique MO par l'intermédiaire d'un réseau de guides d'onde internes à la source 1. Le rayonnement lumineux multispectral RLM produit par le mélangeur optique MO est guidé par le réseau de guides d'onde interne sur un port P1, P2 de la source 1. Il se propage dans un guide d'onde externe couplé à ce port P1, P2.

Le guide d'onde externe est lui-même couplé à un composant photonique MRA1,MRA2, disposé donc optiquement en aval de la source 1 et de la banque de laser B, le composant photonique comprenant une pluralité de filtres optiques présentant, respectivement, des fréquences de résonance accordables. Dans un tel composant photonique, la fréquence de résonance de chaque filtre est accordable individuellement. Le composant photonique MRA1,MRA2 conditionne le rayonnement lumineux multispectral reçu sur son port d'entrée selon la fonction réalisée par ce composant.

Dans l'exemple conforme à l'invention représenté sur les figures 8a, 8b, deux modulateurs radiofréquence MRA1,MRA2 mettant en œuvre chacun un réseau de micro résonateurs indépendants, sont respectivement optiquement relié à deux ports P1,P2 de la source laser 1. Comme cela est bien connu en soi dans le domaine des télécommunications, un modulateur radiofréquence permet de conditionner chaque raie spectrale du rayonnement lumineux multispectral (ici à l'aide de micro résonateurs respectivement accordés à ces raies) pour transmettre de manière multiplexée en fréquence des signaux d'information.

On a ainsi représenté plus en détail sur la figure 9a, un exemple d'un tel modulateur radiofréquence. Un réseau de micro résonateurs en anneau MR1-MR3 est disposé entre un premier et un second guide d'onde WG1,WG2. Le premier guide d'onde WG1 est traversant entre un port d'entrée Pin, sur lequel est fourni le rayonnement lumineux multispectral à moduler, et un port de sortie Pt dit « de transmission » (« through port » selon la dénomination anglo-saxonne), sur lequel est produit le rayonnement lumineux modulé. Le second guide d'onde WG2 est relié à un port de sortie de pertes Pd (« drop port » selon la dénomination anglo-saxonne). Chaque micro résonateur est exploité pour moduler une fréquence d'émission de la source 1 par l'intermédiaire d'un signal radiofréquence RF1-RF3. Chaque micro résonateur en anneau MR1-MR3 est associé à un moyen d'ajustement H1,H2,H3 de sa fréquence de résonance F01,F02,F03, par exemple un réchauffeur. Dans un tel modulateur radiofréquence MRA, on cherche à positionner la fréquence de résonance F01,F02,F03 de chaque micro résonateur MR1-MR3 relativement à une raie spectrale FLa,FLb,FLc du rayonnement multispectral produit par la source 1, selon la configuration de la figure 1d, c'est-à-dire dans une partie linéaire de la fonction de transfert TF1-TF3 du micro résonateur MR1-MR3. On recherche bien entendu à allouer une raie d'émission distincte à chaque micro résonateur. Comme cela est illustré sur la figure 9b, on exploite les moyens d'ajustement H1-H3 associés aux micro résonateurs MR1-MR3 pour ajuster les fréquences de résonance originelles F01,F02,F03 vers les fréquences optimisées F01',F02',F03'.

Revenant à la description des figures 8a,8b, les micro-résonateurs MR du réseau de micro résonnateurs du modulateur radiofréquence MRA1, MRA2 sont respectivement associés à des dispositifs d'ajustement H permettant d'ajuster indépendamment leur fréquence de résonance, notamment pour les verrouiller sur les raies spectrales auxquelles on souhaite les associer.

On note que cette association peut se faire avec beaucoup de flexibilité, par exemple en associant le micro-résonateur et le laser dont les fréquences de résonance et d'émission sont les plus proches. Les solutions de l'état de la technique selon lesquels le signal de modulation est appliqué sur les micro résonateurs ne permettent pas une telle flexibilité, car on ne peut déterminer à quel laser un micro résonateur est associé.

On a également prévu un photodétecteur de surveillance PD1, PD2 optiquement en aval du composant photonique MRA1,MRA2, ici sur un port de sortie de transmission du composant photonique MRA1,MRA2, afin d'établir un signal électrique représentatif du rayonnement multispectral RLM1,RLM2. On peut à cet effet prélever une petite partie de ce rayonnement multispectral RLM1,RLM2 et coupler cette partie prélevée au photodétecteur de surveillance PD1, PD2, comme cela est représenté sur les figures 8a,8b.

Dans une variante représentée en figure 8c, et afin d'éviter de prélever une partie du rayonnement multispectral RLM1,RLM2 se propageant à partir du port de transmission Pt du composant photonique MRA1,MRA2, on peut prévoir de coupler le photodétecteur de surveillance PD1, PD2 directement sur un port de perte Pt du composant photonique MRA1,MRA2.

Un dispositif de verrouillage R recueille le signal V1, V2 fourni par le photodétecteur de surveillance PD1, PD2 et produit les signaux de commande Cd11,Cd12,Cd13 ; Cd21,Cd22,Cd23 permettant de contrôler indépendamment les dispositifs d'ajustements H des filtres optiques MR composant le composant photonique MRA1,MRA2, et donc d'ajuster leurs fréquences de résonance à une fréquence d'émission donnée. Le dispositif de verrouillage R exploite les mêmes principes que ceux présentés en figures 1a à 1e pour déterminer ces signaux de commande. Lorsque le composant photonique MRA1,MRA2 est un modulateur, et comme on l'a déjà précisé, il est préférable de positionner une fréquence d'émission du rayonnement multispectral RLM dans une portion linéaire de la fonction de transfert du filtre formé par le micro résonateur. On peut ainsi chercher à fixer le rapport entre la part de signal présent dans la seconde harmonique et la part du signal présent dans la composante principale pour qu'il soit égal à une valeur cible ou pour le maximiser.

On peut exploiter ce dispositif de verrouillage R en multiplexage temporel (figure 8b) dans lequel il est configuré pour commander le modulateur M et sélectionner, à l'aide du signal de sélection Sel, le laser accordable La,Lb,Lc auquel est appliqué le signal de modulation Vd.

On peut également exploiter le dispositif de verrouillage R en multiplexage fréquentiel (figure 8a) dans lequel le modulateur M génère une pluralité de signaux de modulation Vda, Vdb, Vdc distincts les uns des autres, les signaux de modulation étant appliqués simultanément aux lasers accordables La,Lb,Lc. Ce mode fréquentiel est particulièrement intéressant à exploiter, car on peut associer et allouer chaque filtre du composant photonique à une fréquence d'émission particulière du rayonnement multispectral reçu sur le port d'entrée.

La figure 9c présente un démodulateur, ce démodulateur formant un autre type de composant optique MR1,MRA2 pouvant être calibré/verrouillé conformément aux principes de l'invention. Dans un tel démodulateur, chaque micro résonateur du réseau de micro résonateurs en anneau MR1-MR3 est disposé entre un premier et un second guide d'onde WG1,WG2. Le premier guide d'onde WG1 présente un port d'entrée Pin sur lequel peut être fourni le rayonnement lumineux multispectral à démoduler et un port de transmission Pt. Les ports de perte des micro résonateurs MR1,MR2,MR3 sont connectés à des photodétecteurs de démodulation PDa, PDb, PDc. Le photodétecteur PD1 est placé sur le premier guide d'onde WG1, au niveau du port de transmission Pt. Chaque micro résonateur MR1-MR3 permet de filtrer et d'extraire du rayonnement lumineux multispectral des signaux radiofréquences RF1,RF2,RF3 respectivement portés par les fréquences d'émission (plutôt désignés « fréquences porteuses » dans ce contexte) FLa,FLb,FLc du rayonnement lumineux multispectral. On retrouve également un moyen d'ajustement H1-H3 de la fréquence de résonance F01-F03, par exemple un réchauffeur, associé à chaque micro résonateur MR1-MR3

En figure 9d on a représenté, à gauche de cette figure, le positionnement relatif des fréquences de résonance F01,F02,F03 des filtres MR1,MR2,MR3 et des fréquences porteuses FLa,FLb,FLc, avant ajustement. On a également représenté, à droite de cette figure 9d, le positionnement relatif des fréquences de résonance ajustée F01',F02',F03' et des fréquences porteuses FLa,FLb,FLc, après ajustement et dans le cas où, volontairement, il est choisi de verrouiller les micro-résonateur MR1,MR2,MR3 sur les porteuses optiques les plus proches FLa,FLb,FLc.

Quel que soit la nature du ou des dispositifs photoniques MRA1,MRA2 présent dans le système photonique, il peut être avantageux d'engager la mise en œuvre du système, au cours d'une phase de démarrage, dans un fonctionnement en multiplexage fréquentiel dans lequel une fréquence de modulation distincte est appliquée sur chaque fréquence d'émission/porteuse Fla,Flb,FLc du rayonnement lumineux multispectral RLM. Par simplicité de mise en œuvre, on peut choisir de produire les uns à la suite des autres, pour ajuster la fréquence de résonance d'un filtre optique à la fois, les signaux de commande permettant de contrôler indépendamment les dispositifs d'ajustement H de chaque micro résonateur MR1,MR2,MR3. Comme on l'a déjà énoncé, ce mode de mis en œuvre permet de maitriser l'association d'un micro résonateur à une fréquence porteuse, là où les solutions de l'état de la technique pouvaient conduire à associer plusieurs micro-résonateurs à une même fréquence porteuse. Une fois cette phase de démarrage réalisée, on peut choisir de produire les signaux de commande concurremment.

Bien entendu l'invention n'est pas limitée aux modes de mise en œuvre décrits et on peut y apporter des variantes de réalisation sans sortir du cadre de l'invention tel que défini par les revendications.

Un système optique conforme à l'invention peut exploiter l'un et l'autre des aspects qui viennent d'être présentés. On peut notamment prévoir un système optique combinant les deux aspects de l'invention, c'est-à-dire présentant un premier dispositif de verrouillage pour ajuster les fréquences d'émission des lasers d'une banque aux fréquences de résonance d'un filtre étalon, et un second dispositif de verrouillage pour ajuster les fréquences de résonance des filtres optiques d'un composant photonique aux fréquences d'émission des lasers de la banque.

## Revendications

1. Système photonique (S) comprenant une source laser (1) apte à émettre au moins un rayonnement lumineux multispectral (RLM) présentant une pluralité de raies spectrales, le système photonique comprenant :
- Une banque de lasers (B) comprenant une pluralité de lasers (La,Lb,Lc), une raie spectrale (FLa,FLb,FLc) du rayonnement lumineux multispectral (RLM) correspondant à une fréquence d'émission d'un laser (La,Lb,Lc) de la banque (B) ;
- un modulateur (M) associé à la banque de lasers (B), le modulateur (M) étant configuré pour générer un signal de modulation (Vd ; Vda,Vdb,Vdc) et pour moduler la fréquence d'émission d'au moins un laser (La,Lb,Lc) de la banque (B);
- un composant photonique (MRA1,MRA2) disposé en aval de la banque de lasers (B) et comprenant une pluralité de filtres optiques (MR) accordables présentant respectivement une pluralité de fréquences de résonance ;
- Un photodétecteur (PD1,PD2) disposé en aval du composant photonique (MRA1,MRA2) pour établir un signal représentatif (V1,V2) d'un rayonnement multispectral produit par le composant photonique (RLM1,RLM2);
- un dispositif de verrouillage (R) configuré pour traiter le signal représentatif du rayonnement multispectral (V1,V2) et ajuster les fréquences de résonance des filtres optiques (MR) accordables du composant photonique (MRA1,MRA2) aux fréquences d'émission des lasers (La,Lb,Lc) de la banque (B).

2. Système photonique (S) selon la revendication précédente dans lequel les filtres optiques (MR) accordables du composant photonique (MRA1,MRA2) sont des micro-résonateurs en anneau.

3. Système photonique (S) selon l'une des revendications précédentes dans lequel les filtres optiques (MR) accordables sont respectivement munis de dispositifs d'ajustement (H) de leur fréquence de résonance.

4. Système photonique (S) selon la revendication précédente dans lequel les dispositifs d'ajustement (H) de la fréquence de résonance sont des réchauffeurs.

5. Système photonique (S) selon l'une des revendications précédentes dans lequel les lasers (La,Lb,Lc) sont des lasers à rétroaction répartie ou des lasers à réflecteur de Bragg distribué.

6. Système photonique (S) selon l'une des revendications précédentes dans lequel le dispositif de verrouillage (R) est configuré pour commander le modulateur (M) et sélectionner, à l'aide d'un signal de sélection (Sel), un laser (La,Lb,Lc) de la banque (B) auquel est appliqué le signal de modulation (Vd).

7. Système photonique (S) selon l'une des revendications 1 à 5 dans lequel le modulateur (M) génère une pluralité de signaux de modulation (Vda,Vdb,Vdc) distincts les uns des autres, les signaux de modulation (Vda,Vdb,Vdc) étant appliqués aux lasers (La,Lb,Lc) de la banque (B).

8. Système photonique (S) selon l'une des revendications précédentes dans lequel l'ajustement des fréquences de résonance des filtres optiques (MR) accordables est réalisé un filtre optique à la fois.

9. Système photonique (S) selon l'une des revendications précédentes dans lequel le modulateur (M) est configuré pour produire un signal de modulation (Vd ; Vda,Vdb,Vdc) sinusoïdal présentant une fréquence de modulation (Fd ; Fda,Fdb,Fdc).

10. Système photonique (S) selon l'une des revendications précédentes dans lequel le dispositif de verrouillage (R) est configuré pour établir une mesure représentative de la puissance présente dans une deuxième harmonique de la fréquence de modulation (Fd ; Fda,Fdb,Fdc) du signal représentatif du rayonnement multispectral (V1,V2).

11. Système photonique (S) selon l'une des revendications précédentes dans lequel le dispositif de verrouillage (R) est configuré pour établir une mesure représentative de la puissance présente dans une composante principale de la fréquence de modulation (Fd ; Fda,Fdb,Fdc) du signal représentatif du rayonnement multispectral (V1,V2).

12. Système photonique (S) selon l'une des revendications précédentes dans lequel le dispositif de verrouillage (R) est configuré pour établir une mesure représentative de la phase de la composante principale de la fréquence de modulation (Fd ; Fda,Fdb,Fdc) du signal représentatif du rayonnement multispectral (V1,V2).

13. Système photonique (S) selon l'une des revendications précédentes dans lequel le composant photonique (MRA1,MRA2) est un modulateur radiofréquence.

14. Système photonique (S) selon l'une des revendications précédentes dans lequel le composant photonique (MRA1,MRA2)est un démodulateur radiofréquence.

## Patentansprüche

1. Photonisches System (S), umfassend eine Laserquelle (1), die geeignet ist, mindestens eine multispektrale Lichtstrahlung (RLM), die eine Vielzahl von Spektrallinien aufweist, zu emittieren, das photonische System umfassend:
- eine Laserbank (B), umfassend eine Vielzahl von Lasern (La, Lb, Lc), wobei eine Spektrallinie (FLa, FLb, FLc) der multispektralen Lichtstrahlung (RLM) einer Emissionsfrequenz eines Lasers (La, Lb, Lc) der Bank (B) entspricht;
- einen der Laserbank (B) zugeordneten Modulator (M), wobei der Modulator (M) konfiguriert ist, um ein Modulationssignal (Vd; Vda, Vdb, Vdc) zu erzeugen und um die Emissionsfrequenz von mindestens einem Laser (La, Lb, Lc) der Bank (B) zu modulieren;
- eine der Laserbank (B) nachgeschaltete photonische Komponente (MRA1, MRA2) und umfassend eine Vielzahl von abstimmbaren optischen Filtern (MR), die jeweils eine Vielzahl von Resonanzfrequenzen aufweist;
- einen Photodetektor (PD1, PD2), der der photonischen Komponente (MRA1, MRA2) nachgeschaltet angeordnet ist, um ein Signal (V1, V2) zu ermitteln, das für die durch die photonische Komponente (RLM1, RLM2) geschaffene multispektrale Strahlung repräsentativ ist;
- eine Verriegelungsvorrichtung (R), die konfiguriert ist, um das für die multispektrale Strahlung (V1, V2) repräsentative Signal zu verarbeiten und die Resonanzfrequenzen der abstimmbaren optischen Filter (MR) der photonischen Komponente (MRA1, MRA2) an die Emissionsfrequenzen der Laser (La, Lb, Lc) der Bank (B) anzupassen.

2. Photonisches System (S) nach dem vorstehenden Anspruch, wobei die abstimmbaren optischen Filter (MR) der photonischen Komponente (MRA1, MRA2) ringförmige Mikroresonatoren sind.

3. Photonisches System (S) nach einem der vorstehenden Ansprüche, wobei die abstimmbaren optischen Filter (MR) jeweils mit Vorrichtungen (H) zum Anpassen ihrer Resonanzfrequenz versehen sind.

4. Photonisches System (S) nach dem vorstehenden Anspruch, wobei die Vorrichtungen (H) zum Anpassen der Resonanzfrequenz Heizeinrichtungen sind.

5. Photonisches System (S) nach einem der vorstehenden Ansprüche, wobei die Laser (La, Lb, Lc) Laser mit verteilter Rückkopplung oder Laser mit verteiltem Bragg-Reflektor sind.

6. Photonisches System (S) nach einem der vorstehenden Ansprüche, wobei die Verriegelungsvorrichtung (R) konfiguriert ist, um den Modulator (M) zu steuern und mittels eines Auswahlsignals (Sel) einen Laser (La, Lb, Lc) der Bank (B), auf die das Modulationssignal (Vd) angewendet wird, auszuwählen.

7. Photonisches System (S) nach einem der Ansprüche 1 bis 5, wobei der Modulator (M) eine Vielzahl von Modulationssignalen (Vda, Vdb, Vdc) erzeugt, die voneinander verschieden sind, wobei die Modulationssignale (Vda, Vdb, Vdc) auf die Laser (La, Lb, Lc) der Bank (B) angewendet werden.

8. Photonisches System (S) nach einem der vorstehenden Ansprüche, wobei die Anpassung der Resonanzfrequenzen der abstimmbaren optischen Filter (MR) jeweils für einen optischen Filter durchgeführt wird.

9. Photonisches System (S) nach einem der vorstehenden Ansprüche, wobei der Modulator (M) konfiguriert ist, um ein sinusförmiges Modulationssignal (Vd; Vda, Vdb, Vdc), das eine Modulationsfrequenz (Fd; Fda, Fdb, Fdc) aufweist, zu schaffen.

10. Photonisches System (S) nach einem der vorstehenden Ansprüche, wobei die Verriegelungsvorrichtung (R) konfiguriert ist, um eine Messung zu ermitteln, die für die in einer zweiten Harmonischen der Modulationsfrequenz (Fd; Fda, Fdb, Fdc) des für multispektrale Strahlung repräsentativen Signals (V1, V2) repräsentativ ist.

11. Photonisches System (S) nach einem der vorstehenden Ansprüche, wobei die Verriegelungsvorrichtung (R) konfiguriert ist, um eine Messung zu ermitteln, die repräsentativ für die in einer Hauptkomponente der Modulationsfrequenz (Fd; Fda, Fdb, Fdc) des für multispektrale Strahlung repräsentativen Signals (V1, V2) ist.

12. Photonisches System (S) nach einem der vorstehenden Ansprüche, wobei die Verriegelungsvorrichtung (R) konfiguriert ist, um eine Messung zu ermitteln, die für die Phase der Hauptkomponente der Modulationsfrequenz (Fd; Fda, Fdb, Fdc) des für multispektrale Strahlung repräsentativen Signals (V1, V2) repräsentativ ist.

13. Photonisches System (S) nach einem der vorstehenden Ansprüche, wobei die photonische Komponente (MRA1, MRA2) ein Hochfrequenzmodulator ist.

14. Photonisches System (S) nach einem der vorstehenden Ansprüche, wobei die photonische Komponente (MRA1, MRA2) ein Hochfrequenzdemodulator ist.

## Claims

1. A photonic system (S) comprising a laser source (1) capable of emitting at least one multispectral light radiation (RLM) having a plurality of spectral lines, the photonic system comprising:
- a bank of lasers (B) comprising a plurality of lasers (La, Lb, Lc), a spectral line (FLa, FLb, FLc) of the multispectral light radiation (RLM) corresponding to an emission frequency of a laser (La, Lb, Lc) of the bank (B);
- a modulator (M) associated with the laser bank (B), the modulator (M) being configured to generate a modulation signal (Vd; Vda, Vdb, Vdc) and to modulate the emission frequency of at least one laser (La, Lb, Lc) of the bank (B);
- a photonic component (MRA1, MRA2) arranged downstream of the laser bank (B) and comprising a plurality of tunable optical filters (MR) each having a plurality of resonant frequencies;
- a photodetector (PD1, PD2) arranged downstream of the photonic component (MRA1, MRA2) to establish a signal (V1, V2) representative of a multispectral radiation produced by the photonic component (RLM1, RLM2);
- a locking device (R) configured to process the signal representative of the multispectral radiation (V1, V2) and to adjust the resonant frequencies of the tunable optical filters (MR) of the photonic component (MRA1, MRA2) to the emission frequencies of the lasers (La, Lb, Lc) of the bank (B).

2. The photonic system (S) according to the preceding claim, wherein the tunable optical filters (MR) of the photonic component (MRA1, MRA2) are ring micro-resonators.

3. The photonic system (S) according to one of the preceding claims, wherein the tunable optical filters (MR) are each provided with devices (H) for adjusting their resonant frequency.

4. The photonic system (S) according to the preceding claim, wherein the resonant frequency adjustment devices (H) are heaters.

5. The photonic system (S) according to one of the preceding claims, wherein the lasers (La, Lb, Lc) are distributed feedback lasers or distributed Bragg reflector lasers.

6. The photonic system (S) according to one of the preceding claims, wherein the locking device (R) is configured to control the modulator (M) and to select, by means of a selection signal (Sel), a laser (La, Lb, Lc) from the bank (B) to which the modulation signal (Vd) is applied.

7. The photonic system (S) according to one of claims 1 to 5, wherein the modulator (M) generates a plurality of modulation signals (Vda, Vdb, Vdc) which are distinct from one another, the modulation signals (Vda, Vdb, Vdc) being applied to the lasers (La, Lb, Lc) of the bank (B).

8. The photonic system (S) according to one of the preceding claims, wherein the adjustment of the resonant frequencies of the tunable optical filters (MR) is performed one optical filter at a time.

9. The photonic system (S) according to one of the preceding claims, wherein the modulator (M) is configured to produce a sinusoidal modulation signal (Vd; Vda, Vdb, Vdc) having a modulation frequency (Fd; Fda, Fdb, Fdc).

10. The photonic system (S) according to one of the preceding claims, wherein the locking device (R) is configured to establish a measurement representative of the power present in a second harmonic of the modulation frequency (Fd; Fda, Fdb, Fdc) of the signal (V1, V2) representative of the multispectral radiation.

11. The photonic system (S) according to one of the preceding claims, wherein the locking device (R) is configured to establish a measurement representative of the power present in a main component of the modulation frequency (Fd; Fda, Fdb, Fdc) of the signal (V1, V2) representative of the multispectral radiation.

12. The photonic system (S) according to one of the preceding claims, wherein the locking device (R) is configured to establish a measurement representative of the phase of the main component of the modulation frequency (Fd; Fda, Fdb, Fdc) of the signal (V1, V2) representative of the multispectral radiation.

13. The photonic system (S) according to one of the preceding claims, wherein the photonic component (MRA1, MRA2) is a radio-frequency modulator.

14. The photonic system (S) according to one of the preceding claims, wherein the photonic component (MRA1, MRA2) is a radio-frequency demodulator.
